# EUROPÄISCHE PATENTSCHRIFT

(11) **EP 3 309 965 B1**
(45) Veröffentlichungstag und Bekanntmachung des Hinweises auf die Patenterteilung: **02.12.2020**
(21) Anmeldenummer: 16193918.6
(22) Anmeldetag: 14.10.2016
(51) Int. Cl.: H03K 17/955, E05F 15/46

(54) **SENSORSYSTEM**
SENSOR SYSTEM
SYSTÈME DE CAPTEUR

(43) Veröffentlichungstag der Anmeldung: 18.04.2018
(73) Patentinhaber: ZSI Technololgy GmbH, 90518 Altdorf b. Nürnberg (DE)
(72) Erfinder: WERBIK, Angela Rebekka, 91227 Leinburg (DE); ROHLEDERER, Helmuth, 91189 Rohr (DE)
(74) Vertreter: Grünecker Patent- und Rechtsanwälte PartG mbB

(56) Entgegenhaltungen:
- DE-A1-102006 008 281
- DE-A1-102006 009 998
- DE-A1-102006 044 778
- DE-A1-102012 110 383
- DE-A1-102013 007 642
- DE-A1-102014 013 213
- DE-U1-202006 013 337

## Beschreibung

Die Erfindung betrifft ein Sensorsystem gemäß dem Oberbegriff des Anspruchs 1 sowie ein Verfahren nach Anspruch 8.

Um zu verhindern, dass Hindernisse, insbesondere Körperteile, beim Schließen eines angetriebenen Verschlusselements, z.B. einer angetriebenen Heckklappe, Türe oder Schiebedach, eingeklemmt werden, werden bislang taktile Sensorsysteme, insbesondere Drucksensoren verwendet. Entsprechende Systeme erkennen ein Hindernis, einen Gegenstand oder ein Körperteil erst bei Kontakt, wobei hierfür ein Schwellwert von bis zu 100 N gilt. Erst dann wird die Bewegung des Verschlusselements, z.B. der Heckklappe, gestoppt. Diese Systeme haben den Nachteil, dass trotz der Sensoren Körperteile eingeklemmt und verletzt werden. Besonders im Hinblick auf das Einklemmen von Kinderhänden herrscht hier deutlicher Verbesserungsbedarf. DE 10 2006 044 778 A1 offenbart ein solches System.

Auch das Öffnen eines Verschlusselements birgt ein gewisses Gefahrenpotential, da Personen, die beim Öffnen des Verschlusselements hinter dem Verschlusselement stehen leicht verletzt werden können. Bewegt sich z.B. eine Heckklappe nach oben kann dabei eine Person zwischen der Außenseite der Heckklappe und einem weiteren Objekt, z.B. einer Garagenwand eingeklemmt werden. Hier gibt es bislang noch keine zufriedenstellenden Lösungen.

Hiervon ausgehend liegt der vorliegenden Erfindung die Aufgabe zugrunde, ein Sensorsystem und Verfahren bereitzustellen, die auf einfache Art und Weise verhindern, dass Hindernisse beim Schließen oder Öffnen eines motorisch angetriebenen Verschlusselements eingeklemmt werden.

Erfindungsgemäß wird diese Aufgabe durch die Merkmale der Ansprüche 1 und 8 gelöst.

Das erfindungsgemäße Sensorsystem ermöglicht, dass auf einfache Art und Weise Hindernisse, wie etwa Körperteile, in einem Öffnungsbereich eines Kraftfahrzeugs beim Schließen eines motorisch angetriebenen Verschlusselements detektiert werden können. Unter Verschlusselement versteht man in dieser Erfindung insbesondere eine Heckklappe eines Kraftfahrzeugs. Genauso kann das erfindungsgemäße Sensorsystem aber auch für elektrisch angetriebene Türen im Seitenbereich des Kraftfahrzeugs oder aber elektrisch angetriebene Schiebedächer oder Kofferraumdeckel oder mit automatischen Fensterhebern angetriebene Fenster als Verschlusselement verwendet werden. Unter Öffnungsbereich versteht man den offenen Bereich in der Fahrzeugkarosserie, der durch das Verschlusselement verschlossen wird. Um zu verhindern, dass Hindernisse zwischen Verschlusselement und Karosserie im Öffnungsbereich eingeklemmt werden oder beim Öffnen beschädigt werden, ist gemäß der vorliegenden Erfindung ein berührungsloser kapazitiver Sensor vorgesehen. Dieser Sensor kann also eine Kapazitätsänderung infolge eines Hindernisses im Bewegungsbereich des angetriebenen Verschlusselements in einen Signalerfassungsbereich des Sensors erfassen - z.B. entweder in einem Bereich zwischen der Innenseite der Heckklappe und dem Öffnungsbereich und/oder in einem Bereich außerhalb der Heckklappe. Das heißt, dass der kapazitive Sensor die Funktion eines Näherungssensors hat, der erkennt, wenn ein Hindernis sich in seinen Signalerfassungsbereich begibt. Somit hat der kapazitive Sensor die Funktion eines Näherungssensors, wobei je näher das Hindernis sich in Richtung Sensor befindet, desto größer die Kapazitätsänderung infolge des Hindernisses ist. Ein Maximalwert ergibt sich bei Berührung.

Eine Auswerteeinheit kann auf der Grundlage des Messwertes des Sensors ein Sensorsignal erzeugen und an eine Motorsteuerung des Verschlusselements leiten, so dass die Geschwindigkeit der Bewegung des Verschlusselements verlangsamt oder gestoppt werden kann.

Das heißt, dass Körperteile nicht nur dann entdeckt werden können, wenn es einen direkten Kontakt mit dem Sensorsystem gibt, sondern bereits reagiert werden kann, wenn sich ein Hindernis dem Verschlusselement nähert. Somit kann ein Einklemmen, wie es bei den taktilen Sensoren üblich ist, verhindert werden. Ein entsprechender Sensor kann kostengünstig und einfach realisiert werden.

Der kapazitive Sensor umfasst ein Sensorelement, um das ein elektrisches Feld erzeugt wird und eine Sensorelektronik zum Erfassen einer Kapazität in dem elektrischen Feld am Sensorelement. Die Sensorelektronik erzeugt dabei einen Messwert, der an eine Auswerteeinheit geleitet wird. Die Sensorelektronik kann auch in der Auswerteeinheit integriert sein. Die Auswerteeinheit vergleicht z.B. die Messergebnisse mit Grenzwerten. Dabei kann die Auswerteeinheit beispielsweise so ausgebildet sein, dass sie einen Messwert des Sensors mit mindestens einem Grenzwert vergleicht oder aber die relative Änderung ΔS_{Mess} des Messwerts bestimmt. Wenn diese relative Änderung größer als eine vorbestimmte relative Änderung, d.h. größer als mindestens ein bestimmter Grenzwert ist, kann ebenfalls bestimmt werden, dass sich ein Hindernis am Sensorelement befindet. Bei Betrachten der relativen Änderung können Einflüsse wie Luftfeuchtigkeit etc. reduziert werden. Bei Überschreiten des Grenzwerts kann dann jeweils ein Sensorsignal an die Motorsteuerung abgegeben werden, wobei dann die Geschwindigkeit des Verschlusselements verlangsamt oder gestoppt wird - wenn dieses Messsignal von der Auswerteeinheit nicht als Störgröße z.B. in Folge von baulichen Hindernissen oder Umgebungsbedingungen identifiziert wird.

Es ist ganz besonders vorteilhaft, wenn das Sensorelement an dem Verschlusselement, hier insbesondere an der Heckklappe, angeordnet ist oder in dem Verschlusselement, insbesondere in der Heckklappe, integriert ist.

Dies bringt den Vorteil mit sich, dass bereits bestehende Komponenten, wie beispielsweise ein Heckklappenblech oder Türblech des Kraftfahrzeugs als Sensorelektrode oder Schirmelektrode für das Sensorsystem verwendet werden können, was eine kostengünstige Realisierung des Systems möglich macht. Dabei ist das Sensorelement des Sensorsystems so angeordnet, dass sich das elektrische Feld z.B. zumindest in den möglichen Einklemmbereichen z.B. in den seitlichen und unteren Kantenbereich einer Heckklappe erstreckt.

Das Sensorelement umfasst dazu vorzugsweise eine flächige Sensorelektrode zur Ausbildung des Signalerfassungsbereichs. Diese Sensorelektrode kann z.B. entweder durch eine leitfähige Folie oder einen leitfähigen Lack gebildet werden, wobei ein Blech des Verschlusselements als Träger dienen kann. Auch ist es möglich, dass die Sensorelektrode durch ein Blech des Verschlusselements gebildet ist, d.h. das Verschlusselement, z.B. die gesamte Heckklappe, als einzig großes Sensorelement fungiert. Eine entsprechende Ausführungsform ist besonders kostengünstig und einfach zu realisieren. Eine Abschirmelektrode kann dann beispielsweise durch ein zweites vom ersten Blech beabstandetes, galvanisch getrenntes Blech der Heckklappe gebildet sein.

Sollte das Sensorelement nicht an den Verschlusselement angeordnet sein, sondern an der Karosserie des Fahrzeugs, so ist es ebenfalls möglich, dass Komponenten der Karosserie, insbesondere ein Karosserieblech, als Teil des Sensorelements verwendet wird, insbesondere als Schirmelektrode oder aber Träger für leitfähige Lacke oder Folien. Dies ermöglicht eine besonders günstige Realisierung des Sensors.

Es ist möglich, dass das Sensorsystem mehrere Sensoren mit mehreren Sensorelementen umfasst, die beispielsweise in verschiedenen Bereichen des Verschlusselements, insbesondere der Heckklappe, angeordnet sind. Somit kann für die einzelnen Sensorelemente bestimmt werden, ob sich ein Hindernis nähert, so dass die Hindernisse lokalisiert werden können.

Der Sensor kann die Kapazitätsänderung in einem Signalerfassungsbereich am Sensorelement messen, wobei sich vorzugsweise der Signalerfassungsbereich von dem Sensorelement ausgehend mit einer Breite 50-100 mm erstreckt. Das heißt, dass das System bereits bei einem Abstand von etwa 100 mm auf ein Hindernis reagieren kann, ohne dass das Hindernis berührt werden muss. Unter Signalerfassungsbereich versteht man den Bereich des elektrischen Feldes in dem ein Messsignal, hier eine Kapazitätsänderung, erfasst werden kann. Der Signalerfassungsbereich erstreckt sich vorzugsweise entweder von einer Seite des Sensorelements aus und / oder von beiden Seiten des Sensorelements aus. Der Signalerfassungsbereich ist zum Öffnungsbereich hin gewandt wenn ein Einklemmen verhindert werden soll. Alternativ oder gleichzeitig erstreckt sich das elektrische Feld um das Verschlusselement herum und ist auch zur gegenüberliegenden Seite gerichtet, so dass auch beim Öffnen des Verschlusselements Hindernisse außerhalb des Verschlusselements, d.h. z.B. an der Außenseite der Heckklappe erfasst werden können.

Gemäß einer bevorzugten Ausführungsform ist in der Auswerteeinheit für eine erste Zone z1 in dem Signalerfassungsbereich, die einen ersten Abstand a zum Sensorelement aufweist, ein erster Grenzwert festgelegt, wobei bei Überschreiten des Grenzwertes ein Sensorsignal an die Motorsteuerung ausgegeben wird, das die Bewegung des Verschlusselements verlangsamt und für eine weitere Zone mit einem weiteren Abstand b, wobei b < a, ein Sensorsignal an die Motorsteuerung ausgegeben wird, die die Bewegung des Verschlusselements stoppt. Somit kann angemessen auf ein sich dem Sensorelement bzw. dem Verschlusselement näherndes Hindernis reagiert werden.

Es ist besonders vorteilhaft, wenn zusätzlich ein kapazitiver Referenzsensor außerhalb des Bewegungsbereichs des Verschlusselements, insbesondere des Schwenkbereichs der Heccklappe angeordnet ist zum Erfassen einer Kapazitätsänderung infolge von Umgebungsbedingungen, z.B. Niederschlägen. Somit können Kapazitätsänderungen aufgrund von Umgebungsbedingungen ausgeblendet werden oder aber Grenzwerte entsprechend angepasst werden. Der Referenzsensor ist ebenfalls mit der Auswerteeinheit verbunden. Die vom Sensorelement ermittelten Kapazitätserhöhungen können, wenn sie ebenfalls von dem Referenzsensor erfasst werden, nicht von der Auswerteeinheit berücksichtigt werden.

Sicherheitshalber kann das Sensorsystem zusätzlich einen taktilen Sensor umfassen, der dann ein Signal an die Motorsteuerung sendet, wenn ein Hindernis tatsächlich durch das Verschlusselement eingeklemmt wurde, beispielsweise einen Drucksensor. Eine entsprechende Kombination sorgt für außerordentliche Sicherheit.

Vor Inbetriebnahme des Sensorsystems ist es vorteilhaft, wenn bei einer Referenzfahrt Kapazitätserhöhungen infolge von Umgebungsbedingungen von der Auswerteeinheit erfasst und abgespeichert sind und im Normalbetrieb des Verschlusselements ausgeblendet bzw. nicht berücksichtigt werden.

Die Erfindung betrifft auch ein Verfahren zum Verhindern, dass Hindernisse im Öffnungsbereich beim Schließen des Verschlusselements eingeklemmt werden oder beim Öffnen beschädigt werden mit folgenden Schritten:
- Bewegen des Verschlusselements zum Schließen oder Öffnen des Öffnungsbereichs, Messen der Kapazität in einem Signalerfassungsbereich eines elektrischen Feldes eines Sensorelements eines kapazitiven Sensors, Leiten des Messwerts an eine Auswerteeinheit, die ein Sensorsignal auf der Grundlage des Messwerts erzeugt und an eine Motorsteuerung des Verschlusselements leitet, wodurch die Bewegung des Verschlusselements entweder verlangsamt oder gestoppt wird.

Die Auswerteeinheit vergleicht entweder einen Messwert des Sensors mit einem Grenzwert oder ermittelt, ob die relative Änderung des Messwerts größer ist als ein vorbestimmter Grenzwert. Bei Überschreiten des Grenzwertes wird jeweils ein Sensorsignal an die Motorsteuerung abgegeben, das die Geschwindigkeit des Verschlusselements verlangsamt oder stoppt.

Das Sensorelement kann an dem Verschlusselement angeordnet oder in dem Verschlusselement integriert sein, so dass auch wenn beispielsweise das Verschlusselement in einer noch relativ weit geöffneten Position befindet - beispielsweise die Heckklappe sich in einem oberen Bereich des Öffnungsbereichs befindet - erkannt werden kann, dass sich ein Hindernis im Öffnungsbereich befindet. Somit kann bereits lange bevor mit einem Einklemmen zu rechnen ist, auf das Hindernis reagiert werden.

Vor Inbetriebnahme des Sensorsystems kann eine Referenzfahrt durchgeführt werden und die Kapazitätserhöhung infolge von baulichen Umgebungsbedingungen von der Auswerteeinheit erfasst werden und im Normalbetrieb des Verschlusselements ausgeblendet werden.

Es ist auch möglich, eine Kapazität mit Hilfe eines externen Referenzsensors außerhalb des Schwenkbereichs zu messen und zu bestimmen, ob der Messwert oder die relative Änderung des Messwerts einen Grenzwert überschreitet, wobei wenn der Grenzwert überschritten wird, bestimmt wird, dass eine gleichzeitige Überschreitung des Grenzwerts, die durch den kapazitiven Sensor festgestellt wird, nicht durch ein Hindernis hervorgerufen wurde und kein Sensorsignal an die Motorsteuerung geschickt wird, das die Bewegung des Verschlusselements entweder verlangsamt oder stoppt

Vorteilhafterweise wird der Messwert mit mehreren Grenzwerten verglichen, wobei insbesondere nach Überschreiten eines ersten Grenzwerts die Geschwindigkeit reduziert und nach Überschreiten eines weiteren Grenzwerts die Bewegung des Verschlusselements gestoppt wird. Die Kapazität kann auch an mehreren Stellen der Heckklappe gemessen werden, wobei vorzugsweise Sensoren an unterschiedlichen Stellen unterschiedliche Grenzwerte zugeordnet werden.

Es ist auch möglich, dass die in der Auswerteeinheit abgelegten Grenzwerte variabel sind, und beispielsweise in Abhängigkeit von Messwerten eines Referenzsensors angepasst werden.

Es ist vorteilhaft, wenn in der Auswerteeinheit Messwerte hinterlegt sind, die Umgebungseinflüssen wie Regen oder Schnee entsprechen und/oder Messwerte für verschiedenen Materialien von Möglichen Hindernissen und die aktuelle Messwerte mit den hinterlegten Messwerten verglichen werden. Dann kann die Auswerteeinheit aktuelle Messwerte mit den Messwerten für Umgebungsbedingungen vergleichen und bei Übereinstimmung unberücksichtigt lassen.

Es ist auch vorteilhaft wenn externe Referenzsensoren, insbesondere ein Regensensor oder eine Rückfahrkamera mit der Auswerteeinheit verbunden sind.

Die vorliegende Erfindung wird nachfolgend unter Bezugnahme folgender Figuren näher erläutert.
- Fig. 1: zeigt grob schematisch ein Kraftfahrzeug mit einem Sensorsystem gemäß einem Ausführungsbeispiel der vorliegenden Erfindung.
- Fig. 2a: zeigt grob schematisch ein Sensorelement in Form einer Heckklappe gemäß einem bevorzugten Ausführungsbeispiel der vorliegenden Erfindung.
- Fig. 2b: zeigt eine Detailansicht eines Kantenbereichs der in Fig. 2a gezeigten Heckklappe.
- Fig. 3a: zeigt grob schematisch das Sensorsystem gemäß einer bevorzugten Ausführungsform.
- Fig. 3b: zeigt das in Fig. 3a gezeigte Sensorsystem mit Referenzsensor gemäß einem weiteren Ausführungsbeil gemäß der vorliegenden Erfindung.
- Fig. 4: zeigt grob schematisch das Prinzip des erfindungsgemäßen kapazitiven Sensors.
- Fig. 5: zeigt grob schematisch ein Blockschaltbild des erfindungsgemäßen Verfahrens.
- Fig. 6a,b,c: zeigen eine detaillierte Ansicht des in dem Verschlusselement integrierten Sensorelements.
- Fig. 7a: zeigt grob schematisch die Innenseite einer Heckklappe mit integriertem Sensorelement entsprechend Fig. 6a.
- Fig. 7b: zeigt grob schematisch die Innenseite einer Heckklappe mit mehreren Sensoren gemäß einem weiteren Ausführungsbeispiel der vorliegenden Erfindung.

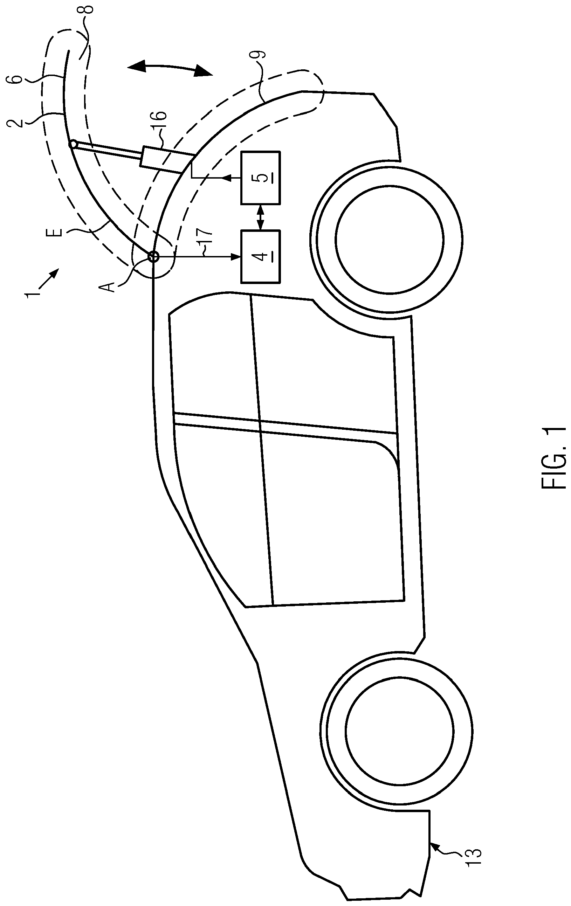

Fig. 1 zeigt grob schematisch eine seitliche Ansicht eines Kraftfahrzeugs, hier eines Autos mit einem erfindungsgemäßen Sensorsystem.

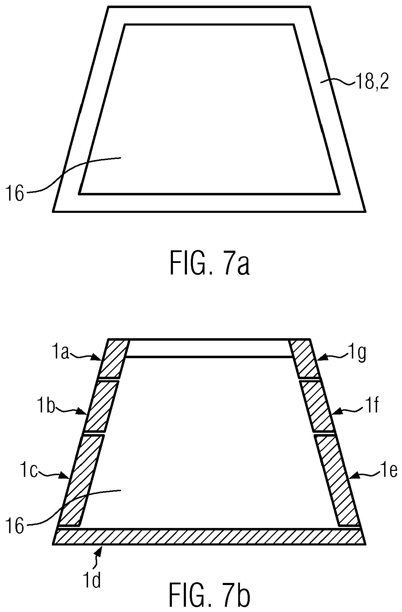

Das erfindungsgemäße Sensorsystem wird hier in Zusammenhang mit einer Heckklappe als Verschlusselement beschrieben. Das Sensorsystem ist gleichermaßen geeignet für andere Verschlusselemente, wie beispielsweise Schiebetüren, Schiebedächer, Kofferraumdeckel, Fenster, die motorisch automatisch angetrieben werden. In Fig. 1 befindet sich die Heckklappe 6 in einer geöffneten Position. Die Heckklappe 6 kann über einen Motor 16, der von einer Motorsteuerung 5 angesteuert wird, von der in Fig. 1 gezeigten geöffneten Position in eine Schließposition, um die Achse A verschwenkt werden. Bei geöffneter Heckklappe ergibt sich der Öffnungsbereich 9 in der Fahrzeugkarosserie. Der Öffnungsbereich erlaubt Zugang zum Innenraum des Kraftfahrzeugs. Der kapazitive Sensor 1 weist ein flächiges Sensorelement 2 auf. Das Sensorelement 2 ist über ein Sensorkabel 17 mit einer Auswerteeinheit 4 verbunden. Bei einer bevorzugten Ausführungsform ist das Sensorelement des Sensors an dem Verschlusselement, hier an der Heckklappe angeordnet bzw. in der Heckklappe integriert. Wie aus Fig. 7a hervorgeht, wird beispielsweise das Blech 19 a der Heckklappe als Sensorelektrode 7 des Sensors, wie nachfolgend noch erläutert wird, verwendet.

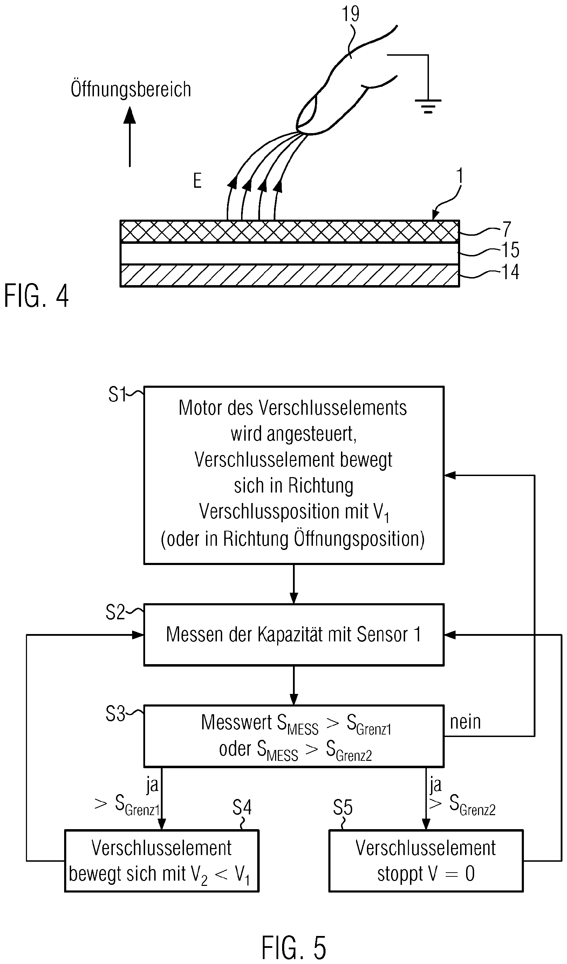

Der Sensor 1 gemäß der vorliegenden Erfindung ist ein kapazitiver Sensor zum Erfassen einer Kapazitätsänderung infolge eines Hindernisses in einem Signalerfassungsbereich 8 des an einem Sensorelement 2 erzeugten elektrischen Feldes E und ist beispielsweise wie in Fig. 4 gezeigt, aufgebaut. Der Messwert erhöht sich mit abnehmendem Abstand des Hindernisses bis zu einem Maximalwert beim Berühren des Sensorelements.

Der Sensor weist ein Sensorelement 2 mit einer Sensorelektrode 7 auf, an die eine Spannung beispielsweise in Höhe von wenigen Volt, z.B. 3,0 - 18 V z.B 3,3 V angelegt wird, um ein elektrisches Feld E zu erzeugen. Das Sensorelement 2 ist hier an der Innenseite des Verschlusses bzw. der Heckklappe angeordnet, wobei die Sensorelektrode 7 z.B. zum Innenraum hin gerichtet ist (bei geschlossener Heckklappe betrachtet). Das Hindernis 19, hier ein Finger, stellt die zweite Elektrode 19 eines Kondensators dar, die geerdet ist. Kapazitive Sensoren basieren darauf, dass zwei Elektroden 19, 7 einen elektrischen Kondensator bilden, dessen Kapazität oder Kapazitätsänderung gemessen wird. Bewegt sich der Finger Richtung Sensorelektrode 7, d.h. verringert sich der Abstand zwischen den Kondensatorelektroden 7, 19, steigt die Kapazität. Mit 15 ist ein galvanische Trennung bezeichnet. Beabstandet von der Sensorelektrode 7 kann eine galvanisch getrennte Schirmelektrode 14 vorgesehen sein, die z.B. den inhomogenen Randbereich des elektrischen Feldes von der Messelektrode 7 abschirmt. Die Schirmelektrode hilft also Einflüsse von EMI und parasitären Kapazitäten zu reduzieren und verbessert somit die Messgenauigkeit. Die optional vorgesehene Schirmelektrode ist entweder geerdet, potenzialfrei oder wird auf ein bestimmtes Spannungspotential gelegt. Bei einer potenzialfreien Abschirmung (oder ohne Schirmelektrode) kann sich das elektrische Feld zu beiden Seiten der Sensorelektrode ausbreiten, wie beispielsweise in der Figur 1 gezeigt ist. Bei einer geerdeten Abschirmung wird das elektrische Feld auf der der Messelektrode 7 gegenüber liegenden Seite geschwächt, so das eine Sensoraktivierung hauptsächlich von der Seite der Messelektrode 7 her möglich ist.

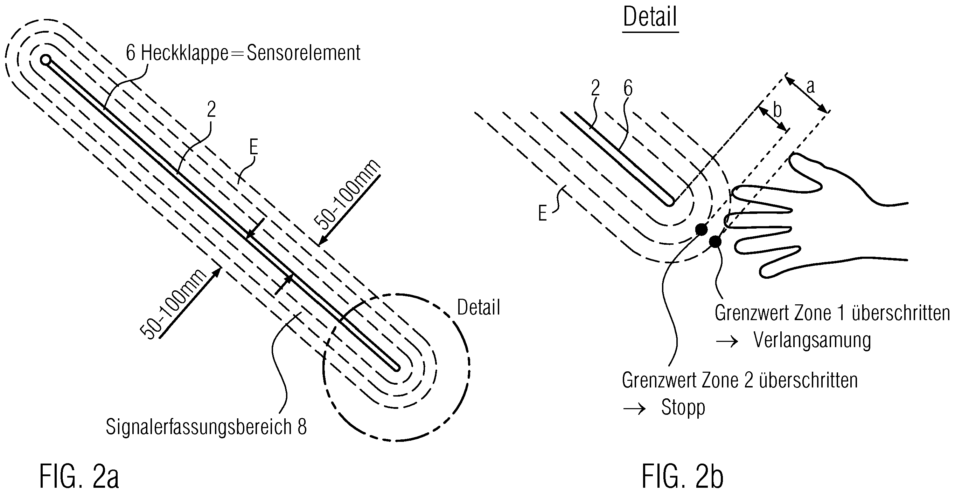

Wie sich z.B. aus den Fig. 1, 2a und 2b ergibt, ergibt sich ein Signalerfassungsbereich 8, so dass mit einer Reichweite beispielsweise von 50 bis zu 100 mm eine Kapazitätsänderung erfasst werden kann, wenn sich ein Hindernis dem Sensorelement 2 bzw. der Sensorelektrode 7 nähert. Der Signalerfassungsbereich 8 erstreckt sich auf der Innenseite und im Kantenbereich des Verschlusselements sowie bei diesem Ausführungsbeispiel auch auf der Außenseite.

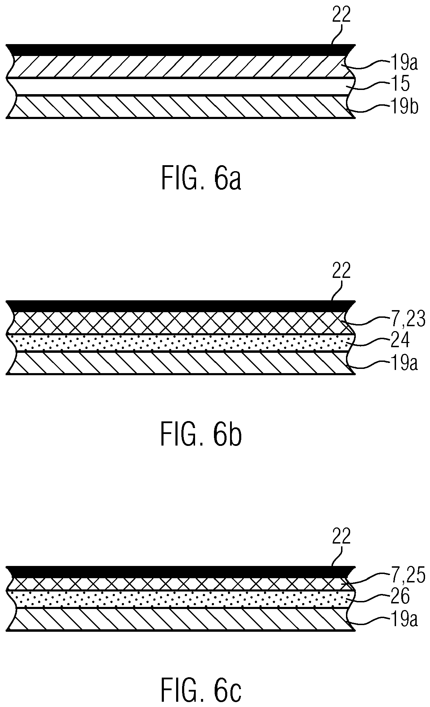

Fig. 6a,b,c zeigen konkrete Ausführungsbeispiele für ein Sensorelement, das in das Verschlusselement, hier die Heckklappe, integriert ist. Heckklappen können beispielsweise aus zwei voneinander beabstandeten Blechen 19a, 19b gebildet sein, die galvanisch voneinander getrennt sind.

Eines der Bleche, hier zum Beispiel das zur Außenseite gewandte Blech 19a fungiert z.B. als Sensorelektrode 7 und wird zur Erzeugung des elektrischen Felds auf ein vorbestimmtes Potenzial aufgeladen wie aus Figur 6a hervorgeht. Das beabstandete, durch z.B. eine Luftschicht oder ein elektrisch isolierendes Material 15 getrennte Blech 19b fungiert hier als Schirmelektrode 14. Auf dem Blech 19 a kann zusätzlich noch ein Decklack 22 aufgebracht sein. Mit dieser Anordnung kann sich das elektrische Feld E, wie es in den Fig. 1, 2a und 2b gezeigt ist, ausbilden. Bei dieser Ausführungsform können sowohl Kapazitätsänderungen aufgrund von Hindernissen auf der Innenseite der Heckklappe identifiziert werden als auch auf der Außenseite. Somit kann nicht nur das Einklemmen von Gegenständen in einem Öffnungsbereichs eines Kraftfahrzeugs verhindert werden, sondern auch die Beschädigung eines Hindernisses, das hinter dem Pkw angeordnet ist, wenn sich die Heckklappe öffnet.

Figur 6b zeigt eine weitere mögliche Ausführung Form. Hier fungiert das Blech 19a als Schirmelektrode bzw. Abschirmblech. Auf dem Blech 19 a ist zunächst ein Isolierlack 24 aufgebracht.

Auf dem Isolierlack 24 befindet sich als Sensorelektrode 7 ein leitfähiger Lack 23. Als Deckschicht kann noch ein Decklack 22 aufgebracht werden, der nicht leitfähig ist.

Eine weitere mögliche Ausführungsform eines Sensors ist in Figur 6c gezeigt. Hier dient das Blech 19 a als Schirmelektrode 14, gefolgt von einer isolierenden Klebeschicht 26 und einer leitfähigen Folie 25, die die Sensorelektrode 7 darstellt. Auch hier kann das Sensorelement noch mit einem Decklack 22 beschichtet sein.

Die gezeigten Ausführungsformen für das Sensorelement 2 sind nicht beschränkend. Wesentlich bei den in Figur 6 gezeigten Ausführungsbeispielen ist, dass vorteilhafterweise bereits bestehende Komponenten des Verschlusselements 6, hier der Heckklappe als Teil des Sensors 1 verwendet werden können, zum Beispiel als Schirmelektrode 14, als Sensorelektrode 7 oder einfach als Träger für eine Sensor- oder Schirmelektrode.

Sollte gemäß einer weiteren Ausführungsform das Sensorelement 2 nicht an den Verschlusselement 6 angeordnet sein, sondern an der Karosserie des Fahrzeugs, so ist es ebenfalls möglich, dass Komponenten der Karosserie, insbesondere ein Karosserieblech, als Teil des Sensorelements verwendet wird, insbesondere als Schirmelektrode oder aber Träger für leitfähige Lacke oder Folien.

Es ist auch möglich, dass das Sensorsystem mehrere kleine Sensoren aufweist, wie beispielsweise in Fig. 7B gezeigt ist, d.h. mehrere Segmente 1a,b,c,d,e,f,g. Die einzelnen Sensorelemente sind dabei galvanisch voneinander getrennt, wobei für jeden Einzelsensor über eine Sensorelektronik eine Kapazitätsänderung erfasst werden kann und an die Auswerteeinheit 4 geleitet werden kann. Somit lässt sich das Hindernis lokalisieren.

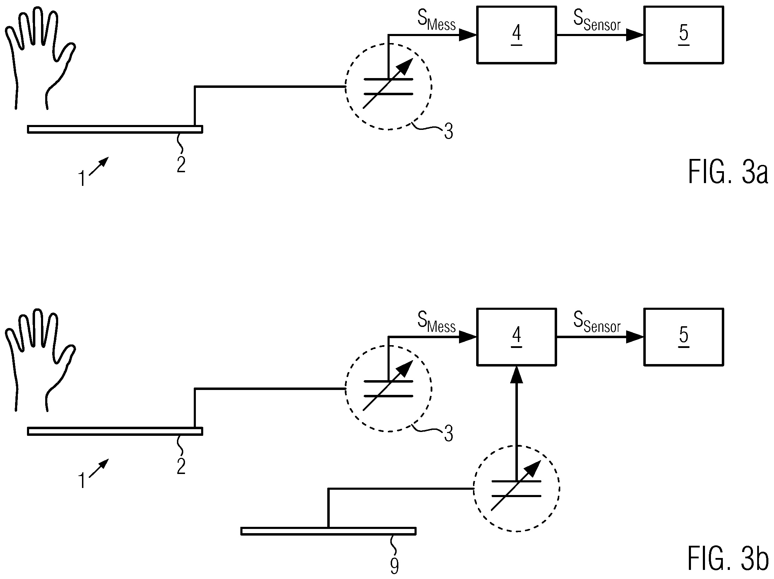

Wie insbesondere auch aus Fig. 3a hervorgeht, kann über eine Sensorelektronik 3 die Kapazitätsänderung im Signalerfassungsbereich 8 des Sensorelements 2 gemessen werden, wobei ein entsprechender Messwert S_{Mess} an eine Auswerteeinheit 4 geleitet werden kann.

Die Auswerteeinheit 4 kann auf der Grundlage des Messwertes S_{Mess} des Sensors 1 ein Sensorsignal S_{Sensor} erzeugen und an eine Motorsteuerung 5 leiten. Wird erkannt, dass sich ein Hindernis im Signalerfassungsbereich 8 des Sensors befindet, wird die Geschwindigkeit der Bewegung des Verschlusselements verlangsamt oder gestoppt.

Die Auswerteeinheit kann so ausgebildet sein, dass sie den Messwert S_{Mess} des Sensors mit einem Grenzwert S_{Grenz} vergleicht oder die relative Änderung ΔS_{Mess} des Messwertes ermittelt und beurteilt, ob diese relative Änderung größer als ein vorbestimmter Grenzwert ist.

Es ist insbesondere möglich, wie aus Fig. 2B hervorgeht, dass in der Auswerteeinheit für eine erste Zone Z1 in dem Signalerfassungsbereich 8, die einen ersten Abstand a zum Sensorelement 2 aufweist, ein erster Grenzwert festgelegt ist und für eine zweite Zone Z2 mit einem Abstand b ein zweiter Grenzwert, wobei b < a. Befindet sich ein Hindernis in der 1. Zone kann die Geschwindigkeit verlangsamt werden, befindet sich ein Hindernissen 2. Zone wird das Verschlusselement gestoppt

Gemäß der vorliegenden Erfindung kann also jeder Fremdkörper mit Dielektrizitätskonstante > 1 (also größer als Luft) als Hindernis erkannt werden.

Wie aus Fig. 3B hervorgeht, kann zusätzlich ein kapazitiver Referenzsensor 9 außerhalb des Bewegungsbereichs des Verschlusselements, hier außerhalb des Schwenkbereichs des Sensors 1, vorgesehen sein. Über diesen Referenzsensor 9 können allgemeine Umgebungsbedingungen unabhängig von etwaigen Hindernissen erfasst werden, wie beispielsweise Niederschläge. Der Referenzsensor ist ebenfalls mit der Auswerteeinheit 4 verbunden. Somit können Kapazitätsänderungen aufgrund von Umgebungsbedingungen ausgeblendet werden oder aber Grenzwerte entsprechend angepasst werden. Es ist auch möglich, mindestens einen weiteren externen Referenzsensor (Regensensor, Rückfahrkamera, PDC) in das System mit einzubinden und mit der Auswerteeinheit zu verbinden. Die Einbindung dieses weiteren Referenzsensors über ein Bussystem (z.B. CAN, LIN, Flexray) ermöglicht es die Plausibilität der Sensormesswerte zu verifizieren.

Durch eine Referenzfahrt der Verschlusseinrichtung, hier der Heckklappe 6, vor Inbetriebnahme, erlernt das Sensorsystem die jeweiligen Einbaubedingungen. Die hier gemessenen Messwerte stellen die Referenzwerte im Normalzustand ohne störende Umgebungseinflüsse dar. Das heißt, dass im Normalbetrieb die bei der Referenzfahrt ermittelten Kapazitätserhöhungen nicht von der Auswerteeinheit berücksichtigt werden.

Weitere typische Umgebungseinflüsse wie Regen oder Schnee können zudem intern zum Beispiel in einem Register im IC hinterlegt werden. Das heißt, dass bei entsprechenden Messsignalen, die an die Auswerteeinheit geleitet werden, bestimmt wird, dass es sich um kein Hindernis im Bereich des beweglichen Verschlusselements handelt und kein entsprechendes Signal an die Motorsteuerung geleitet wird. Ebenso können hier typische Messwerte für Materialien von möglichen Störkörpern hinterlegt werden (Körperteile, Hand, Holz, Kunststoff).

Es kann ein "switched Kondensator-Modus" verwendet werden, um die Energie im Sensorkondensator zu speichern. Die Kapazität kann als Analogwert gemessen werden und in einen Digitalwert umgewandelt werden. Die Digitalwerte können in einem Register abgespeichert werden. Es kann zum Beispiel ein C++-Programm die Werte des Registers auslesen und einen Abgleich mit den zulässigen Grenzwerten durchführen. Der Messbereich des Sensors liegt beispielsweise in einem Bereich von -15 pF bis 100 pF. Das System eignet sich für einen Temperatureinsatzbereich von -40° bis 125°C. Die Versorgungsspannung für die Sensorelektrode liegt z.B. bei 3,3 V. Die elektrische Ladung der Sensorelektrode liegt in einem Bereich von Q=1,65x10⁻¹¹C und die elektrische Energie liegt in einem Bereich E=2,7225x10⁻¹¹J. Ein High-speed-32-bit-ASIC ermöglicht sehr kurze Reaktionszeiten. Automotiv-Interface-Communication-Protokoll z.B.: I²C.

Das Sensorsystem kann zusätzlich zu dem kapazitiven Sensor einen taktilen Sensor, z.B. einen Drucksensor, umfassen.

Das erfindungsgemäße Verfahren wird anhand der Fig. 5 näher erläutert. Zunächst wird das erfindungsgemäße Verfahren beim Schließen eines Verschlusselements, hier einer Heckklappe 6, beschrieben.

Zunächst wird der Motor des Verschlusselements über die Motorsteuerung 5 angesteuert, derart, dass sich das Verschlusselement in Richtung Verschlussposition mit einer Geschwindigkeit v₁ bewegt, Schritt S1. Währenddessen wird kontinuierlich die Kapazität mit dem Sensor 1 gemessen, Schritt S2. Die Messwerte werden an die Auswerteeinheit 4 geleitet, wobei hier verglichen wird, ob S_{Mess} > S_{Grenz1} oder S_{Mess} > S_{Grenz2} ist, Schritt S3. Wenn der Messwert nicht größer als der Grenzwert ist, fährt entsprechend Schritt S1 die Heckklappe weiter in Richtung Verschlussposition mit der dafür vorgesehenen Geschwindigkeit, z.B. v₁, Schritt S1. Überschreitet der Messwert den ersten Grenzwert S_{Grenz1}, so erhält die Motorsteuerung ein Sensorsignal, derart, dass der Motor angesteuert wird, dass sich die Bewegung der Heckklappe verlangsamt und mit einer Geschwindigkeit v₂ < v₁ weiter fährt , Schritt S4. Ist der Messwert S_{Mess} sogar größer als der zweite Grenzwert S_{Grenz2}, so kann bestimmt werden, dass sich das Hindernis bereits in der zweiten Zone Z2 befindet und die Motorsteuerung 5 erhält ein Messsignal, derart, dass sie den Motor der Heckklappe so ansteuert, dass diese stoppt, Schritt S5. Zusätzlich kann programmiert werden, dass die Heckklappe nach dem stoppen wieder etwas öffnet (im Falle des Schließvorgangs).

Die Kapazität wird kontinuierlich durch den Sensor 1 weiter gemessen und wenn ein neuer Vergleich in der Auswerteeinheit 4 ergibt, dass die Grenzwerte nicht mehr überschritten werden, so kann sich die Heckklappe weiter entsprechend Schritt S1 mit der vorgesehenen Geschwindigkeit v₁ nach unten bewegen.

Das in Fig. 5 gezeigte Ausführungsbeispiel beschreibt ein Verfahren nun, mit dem ein Einklemmen eines Hindernisses in einem Öffnungsbereich 12 verhindert wird. Dazu muss der Sensor derart angeordnet sein, dass sich der Signalerfassungsbereich zumindest nach innen (in Bezug auf die geschlossene Heckklappe) erstreckt. Erstreckt sich das elektrische Feld auch, wie in Fig. 2a gezeigt ist, alternativ oder zusätzlich nach außen, so kann das in Fig. 5 gezeigte Verfahren derart modifiziert werden, dass der Motor das Verschlusselement aus einer geschlossenen Position in Richtung einer Öffnungsposition mit der Geschwindigkeit v₁ bewegt, Schritt S1. Wird dann ein Hindernis durch den Sensor 1 erkannt, wird, wie zuvor beschrieben, entweder die Geschwindigkeit verlangsamt oder aber das Verschlusselement gestoppt.

Die vorliegende Erfindung ermöglicht, dass es zu keiner Bewegung des Verschlusselements kommt, sobald sich ein Hindernis im Bewegungsbereich des Verschlusselements befindet.

Obwohl die vorherigen Ausführungsbeispiele in Zusammenhang mit einer Heckklappe beschrieben wurden, gelten die vorherigen Ausführungen in gleicher Weise für die zuvor beschriebenen möglichen Verschlusselemente eines Kraftfahrzeugs, wie beispielsweise Kofferraumdeckel, Schiebetür, Schiebedach, Fenster, die motorisch automatisch angetrieben werden.

## Patentansprüche

1. Sensorsystem zum Verhindern, dass Hindernisse beim Schließen eines motorisch angetriebenen Verschlusselements (6), insbesondere einer motorisch angetriebenen Heckklappe, in einem Öffnungsbereichsbereich (12) eines Kraftfahrzeugs (13) eingeklemmt werden und/oder beim Öffnen des Verschlusselements beschädigt werden, wobei das Sensorsystem umfasst:
- einen kapazitiven Sensor (1) zum Erfassen einer Kapazitätsänderung infolge eines Hindernisses,
wobei der kapazitive Sensor (1) die Funktion eines Näherungssensors hat, der erkennt, wenn ein Hindernis sich in seinem Signalerfassungsbereich begibt, wobei je näher ein Hindernis sich in Richtung Sensor befindet, desto größer die Kapazitätsänderung in Folge des Hindernisses ist,
- eine Auswerteeinheit (4), die auf der Grundlage eines Messwerts (S_{Mess}) des Sensors (1) ein Sensorsignal (Sₛₑₙₛₒᵣ) erzeugen und an eine Motorsteuerung (5) leiten kann, das die Geschwindigkeit der Bewegung des Verschlusselements (6) verlangsamt oder stoppt,
wobei der Sensor (1) umfasst:
- ein Sensorelement (2), um das ein elektrisches Feld erzeugt wird, und
- eine Sensorelektronik (3) zum Erfassen einer Kapazität in dem elektrischen Feld am Sensorelement (2) **dadurch gekennzeichnet, dass**
das Sensorelement (2) eine flächige Sensorelektrode (7) zur Ausbildung des Signalerfassungsbereichs umfasst, die eine leitfähige Folie (25) oder einen leitfähigen Lack (23) umfasst, wobei ein Blech (19a) des Verschlusselements als Träger dient oder die Sensorelekrode (7) das Blech (19a) des Verschlusselements (6) umfasst.

2. Sensorsystem nach Anspruch 1, **dadurch gekennzeichnet, dass** die Auswerteeinheit (4) ausgebildet ist zum Vergleichen des Messwerts (S_{Mess}) des Sensors (1) mit einem Grenzwert (S_{Grenz}), oder
die Auswerteeinheit (4) ermitteln kann, ob die relative Änderung (ΔS_{Mess}) des Messwerts größer ist als ein vorbestimmter Grenzwert, und
bei Überschreiten des Grenzwerts jeweils ein Sensorsignal (Sₛₑₙₛₒᵣ) an eine Motorsteuerung (5) abgegeben werden kann, das die Geschwindigkeit des Verschlusselements (6) verlangsamt oder stoppt wobei vorzugsweise
in der Auswerteeinheit (4) für eine erste Zone (Z1) in dem Signalerfassungsbereich, die einen ersten Abstand (a) zum Sensorelement (2) aufweist, ein erster Grenzwert (S_{Grenz} 1) festgelegt ist, wobei bei Überschreiten des Grenzwerts (S_{Grenz1}) ein Sensorsignal (Ssensor) an die Motorsteuerung (5) ausgegeben wird, das die Bewegung des Verschlusselements (6) verlangsamt und
für eine weitere Zone (Z2) mit einem weiteren Abstand (b), wobei b < a, ein Sensorsignal (S_{Sensor}) an die Motorsteuerung ausgegeben wird, die die Bewegung des Verschlusselements (6) stoppt.

3. Sensorsystem nach einem der Ansprüche 1-2, **dadurch gekennzeichnet, dass** das Sensorelement (2) an dem Verschlusselement (6), insbesondere an der Heckklappe (6) angeordnet oder in dem Verschlusselement (6), insbesondere in der Heckklappe (6) integriert ist, wobei vorzugsweise
bestehende Komponenten des Verschlusselements (16) als Teil des Sensorelements (2) verwendet werden.

4. Sensorsystem nach Anspruch 1, **dadurch gekennzeichnet, dass**, das Blech (19a) des Verschlusselements (6) als Sensorelektrode (7) dient und ein beabstandetes galvanisch getrenntes Blech (19b) als Schirmelektrode (14).

5. Sensorsystem nach mindestens einem der Ansprüche 1-4, **dadurch gekennzeichnet, dass** mehrere Sensoren (1a,b,c,d) mit mehreren Sensorelementen (2a,b,c,d) zur Lokalisierung der Hindernisse vorgesehen sind.

6. Sensorsystem nach mindestens Anspruch 1, **dadurch gekennzeichnet, dass** der Sensor (1) die Kapazitätsänderung in einem Signalerfassungsbereich (8) am Sensorelement (2) misst, wobei sich der Signalerfassungsbereich vorzugsweise entweder von einer Seite des Sensorelements (2) aus erstreckt und / oder von beiden Seiten des Sensorelements (2) und sich der Signalerfassungsbereich insbesondere 50 mm - 100 mm von dem Sensorelement aus erstreckt.

7. Sensorsystem nach mindestens einem der Ansprüche 1-6, **dadurch gekennzeichnet, dass** ein kapazitiver Referenzsensor (9) außerhalb des Bewegungsbereichs des Verschlusselements, insbesondere des Schwenkbereichs der Heckklappe (6) angeordnet ist zum Erfassen einer Kapazitätsänderung infolge von Umgebungsbedingungen, insbesondere Niederschläge.

8. Verfahren zum Verhindern, dass Hindernisse im Öffnungsbereich (12) beim Schließen eines motorisch angetriebenen Verschlusselements (6) eingeklemmt werden und/oder beim Öffnen beschädigt werden, insbesondere mit einer Vorrichtung nach mindestens einem der Ansprüche 1-7, mit folgenden Schritten:
- Bewegen des Verschlusselements (6) zum Schließen oder Öffnen des Öffnungsbereichs (12),
- Messen der Kapazität in einem Signalerfassungsbereich (8) eines elektrischen Feldes (11) eines Sensorelements (2) eines kapazitiven Sensors (1),
- Leiten des Messwertes (S_{Mess}) an eine Auswerteeinheit (4), die ein Sensorsignal (S_{Sensor}) auf der Grundlage des Messwertes erzeugt und an eine Motorsteuerung (5) des Verschlusselementes (6) leitet, wodurch die Bewegung des Verschlusselements (6) entweder verlangsamt oder gestoppt wird,
wobei der kapazitive Sensor (1) die Funktion eines Näherungssensors hat, der erkennt, wenn ein Hindernis sich in seinem Signalerfassungsbereich begibt, wobei je näher ein Hindernis sich in Richtung Sensor befindet, desto größer die Kapazitätsänderung in Folge des Hindernisses ist.
**dadurch gekennzeichnet, dass** das Sensorelement (2) eine flächige Sensorelektrode (7) zur Ausbildung des Signalerfassungsbereichs umfasst, die eine leitfähige Folie (25) oder einen leitfähigen Lack (23) umfasst, wobei ein Blech (19a) des Verschlusselements als Träger dient, oder
die Sensorelekrode (7) das Blech (19a) des Verschlusselements (6) umfasst.

9. Verfahren nach Anspruch 8, **dadurch gekennzeichnet, dass** die Auswerteeinheit entweder einen Messwert (S_{Mess}) des Sensors (1) mit einem Grenzwert(S_{Grenz}) vergleicht oder
ermittelt, ob die relative Änderung des Messwerts größer ist als ein vorbestimmter Grenzwert und
bei Überschreiten des Grenzwerts jeweils ein Sensorsignal (Sₛₑₙₛₒᵣ)an die Motorsteuerung (5) abgegeben wird, dass die Geschwindigkeit des Verschlusselements (6) verlangsamt oder stoppt und/oder
der Messwert (S_{Mess}) mit mehreren Grenzwerten verglichen wird, wobei insbesondere nach Überschreiten eines ersten Grenzwerts (S_{Grenz} 1) die Geschwindigkeit reduziert und nach Überschreiten eines weiteren Grenzwertes (S_{Grenz} 2) die Bewegung des Verschlusselements gestoppt wird.

10. Verfahren nach Anspruch 8 oder 9, **dadurch gekennzeichnet, dass** das Sensorelement an dem Verschlusselement (6) angeordnet oder in dem Verschlusselement (6) integriert ist.

11. Verfahren nach mindestens einem der Ansprüche 8-10, **dadurch gekennzeichnet, dass** eine Referenzfahrt vor Inbetriebnahme des Sensorsystems durchgeführt wird und Kapazitätserhöhungen infolge von Umweltbedingungen von der Auswerteeinheit (4) erfasst werden und im Normalbetrieb des Verschlusselements (6) ausgeblendet werden.

12. Verfahren nach mindestens einem der Ansprüche 8-11, **dadurch gekennzeichnet, dass** eine Kapazität mit Hilfe eines kapazitiven Referenzsensors (9) außerhalb des Bewegungsbereichs des Verschlusselements (6) gemessen wird und bestimmt wird, ob der Messwert oder die relative Änderung des Messwerts einen Grenzwert überschreitet, wobei wenn der Grenzwert überschritten wird, bestimmt wird, dass eine gleichzeitige Überschreitung eines Grenzwertes (S_{Grenz}), die durch den kapazitiven Sensor (1) festgestellt wird, nicht durch ein Hindernis hervorgerufen wurde und kein Sensorsignal (S_{Sensor}) an die Motorsteuerung geschickt wird, das die Bewegung des Verschlusselements (6) entweder verlangsamt oder stoppt.

13. Verfahren nach mindestens einem der Ansprüche 8-12, **dadurch gekennzeichnet, dass**, in der Auswerteeinheit (4) Messwerte hinterlegt sind, die Umgebungseinflüssen wie Regen oder Schnee entsprechen und/oder Messwerte für verschiedenen Materialien von möglichen Hindernissen und die aktuellen Messwerte mit den hinterlegten Messwerten verglichen werden.

14. Sensorsystem nach mindestens einem der Ansprüche 1-7, **dadurch gekennzeichnet, dass** externe Referenzsensoren, insbesondere ein Regensensor oder eine Rückfahrkamera mit der Auswerteeinheit (4) verbunden sind.

## Claims

1. A sensor system for preventing obstacles from being trapped in an opening area (12) of a motor vehicle (13) when closing a motor-driven closing element (6), in particular a motor-driven tailgate, and/or from being damaged when opening the closing element, wherein the sensor system comprises
- a capacitive sensor (1) for detecting a change in capacitance due to an obstacle, wherein the capacitive sensor (1) has the function of a proximity sensor which detects when an obstacle enters its signal detection area, wherein the closer an obstacle is to the sensor, the greater the change in capacitance due to the obstacle is,
- an evaluation unit (4) which can generate a sensor signal (Sₛₑₙₛₒᵣ) which slows down or stops the movement of the closing element (6) on the basis of a measured value (S_{Mess}) of the sensor (1) and transmit this signal to a motor controller (5), ,
wherein the sensor (1) comprises
- a sensor element (2) around which an electric field is generated, and
- sensor electronics (3) for detecting a capacitance in the electric field at the sensor element (2), **characterized in that**
the sensor element (2) comprises a flat sensor electrode (7) for forming the signal detection area, which comprises a conductive film (25) or a conductive paint (23), wherein a metal sheet (19a) of the closing element serves as a substrate or
the sensor electrode (7) comprises the metal sheet (19a) of the closing element (6).

2. Sensor system according to claim 1, **characterized in that** the evaluation unit (4) is configured to compare the measured value (S_{Mess}) of the sensor (1) with a threshold (S_{Grenz}), or the evaluation unit (4) can determine whether the relative change (S_{Mess}) of the measured value exceeds a predetermined threshold, and
when the threshold is exceeded, a sensor signal (Sₛₑₙₛₒᵣ) which slows down or stops the closing element (6) can be output to the motor controller (5), wherein preferably
a first threshold (S_{Grenz} 1) is defined in the evaluation unit (4) for a first zone (Z1) in the signal detection area, which has a first distance (a) from the sensor element (2), and when the threshold (S_{Grenz} 1) is exceeded a sensor signal (S_{Sensor}) which slows down the movement of the closing element (6) is output to the motor controller (5), and
for a further zone (Z2) with a longer distance (b), wherein b < a, a sensor signal (S_{Sensor}) which stops the movement of the closing element (6) is output to the motor controller.

3. Sensor system according to one of claims 1-2, **characterized in that** the sensor element (2) is arranged at the closing element (6), in particular at the tailgate (6), or is integrated into the closing element (6), in particular the tailgate (6), wherein preferably existing components of the closing element (16) are used as part of the sensor element (2).

4. Sensor system according to claim 1, **characterized in that** the metal sheet (19a) of the closing element (6) serves as a sensor electrode (7) and a spaced, galvanically separated metal sheet (19b) serves as a shield electrode (14).

5. Sensor system according to at least one of claims 1-4, **characterized in that** a plurality of sensors (1a,b,c,d) with a plurality of sensor elements (2a,b,c,d) are provided for locating the obstacles.

6. Sensor system according to at least Claim 1, **characterized in that** the sensor (1) measures the change in capacitance in a signal detection area (8) at the sensor element (2), the signal detection area preferably extending either from one side of the sensor element (2) and/or from both sides of the sensor element (2) and the signal detection area extending in particular over 50 mm - 100 mm from the sensor element.

7. Sensor system according to at least one of claims 1-6, **characterized in that** a capacitive reference sensor (9) is arranged outside the range of movement of the closing element, in particular the pivoting range of the tailgate (6), for detecting a change in capacitance as a result of environmental conditions, in particular precipitation.

8. Method for preventing obstacles from being trapped in an opening area (12) when closing a motor-driven closing element (6) and/or from being damaged when opening, in particular with a device according to at least one of claims 1- 8, comprising the following steps:
- moving the closing element (6) to close or open the opening area (12),
- measuring the capacitance in a signal detection area (8) of an electric field (11) of a sensor element (2) of a capacitive sensor (1),
- sending the measured value (S_{Mess}) to an evaluation unit (4), which generates a sensor signal (S_{Sensor}) on the basis of the measured value and sends it to a motor controller (5) of the closing element (6), whereby the movement of the closing element (6) is either slowed down or stopped,
wherein the capacitive sensor (1) has the function of a proximity sensor which detects when an obstacle enters its signal detection area, wherein the closer an obstacle is to the sensor, the greater the change in capacitance due to the obstacle is,
**characterized in that** the sensor element (2) comprises a flat sensor electrode (7) for forming the signal detection area, which comprises a conductive film (25) or a conductive paint (23), wherein a metal sheet (19a) of the closing element serves as a substrate or
the sensor electrode (7) comprises the metal sheet (19a) of the closing element (6).

9. Method according to claim 8, **characterized in that** the evaluation unit either compares a measured value (S_{Mess}) of the sensor (1) with a threshold (S_{Grenz}) or
determines whether the relative change in the measured value exceeds a predetermined threshold and
when the threshold is exceeded, a sensor signal (Sₛₑₙₛₒᵣ) which slows down or stops the closing element (6) is output to the motor controller (5), and/or
the measured value (S_{Mess}) is compared with a plurality of thresholds, the speed is reduced in particular after a first threshold (S_{Grenz} 1) is exceeded and the movement of the closing element is stopped after a further threshold (S_{Grenz} 2) is exceeded.

10. Method according to claim 8 or 9, **characterized in that** the sensor element is arranged at the closing element (6) or is integrated in the closing element (6).

11. Method according to at least one of claims 8-10, **characterized in that** a reference run is carried out before the sensor system is put into operation and increases in capacity due to environmental conditions are detected by the evaluation unit (4) which are ignored during normal operation of the closing element (6).

12. Method according to at least one of claims 8-11, **characterized in that** a capacitance is measured using a capacitive reference sensor (9) outside the range of movement of the closing element (6) and it is determined whether the measured value or the relative change in the measured value exceeds a threshold, wherein if the threshold is exceeded, it is determined that a simultaneous exceeding of a threshold (S_{Grenz}) detected by the capacitive sensor (1), was not caused by an obstacle and no sensor signal (S_{Sensor}) which either slows down or stops the movement of the closing element (6) is sent to the motor controller unit.

13. Method according to at least one of claims 8-12, **characterized in that** in the evaluation unit (4) measured values are registered which correspond to environmental influences such as rain or snow and/or measured values for different materials of potential obstacles and the current measured values are compared with the registered measured values.

14. Sensor system according to at least one of claims 1-7, **characterized in that** external reference sensors, in particular a rain sensor or a rear view camera, are connected to the evaluation unit (4).

## Revendications

1. Système de capteur permettant d'empêcher que des obstacles soient coincés dans une région d'ouverture (12) d'un véhicule automobile (13) lors de la fermeture d'un élément de fermeture (6) entrainé de manière motorisée, en particulier un hayon entrainé de manière motorisée, et/ou ne soient endommagés lors de l'ouverture de l'élément de fermeture, dans lequel le système de capteur comprend :
- un capteur capacitif (1) permettant de détecter une variation de capacité dû à un obstacle,
dans lequel le capteur capacitif (1) possède la fonction de capteur de proximité qui détecte le déplacement d'un obstacle dans sa région de détection de signal, dans lequel la variation de capacité due à l'obstacle est d'autant plus grande que l'obstacle est plus proche du capteur,
- une unité d'évaluation (4) qui, en se basant sur une valeur de mesure (S_{Mess}) du capteur (1), peut générer un signal de capteur (Sₛₑₙₛₒᵣ) ralentissant la vitesse du déplacement de l'élément de fermeture (6) ou arrêtant ledit déplacement et peut le transmettre à une commande de moteur (5),
dans lequel le capteur (1) comprend :
- un élément formant capteur (2) autour duquel est généré un champ électrique, et
- une électronique de capteur (3) permettant de détecter une capacité dans le champ électrique au niveau de l'élément formant capteur (2), **caractérisé en ce que**
l'élément formant capteur (2) comprend une électrode de capteur (7) plate permettant de former la région de détection de signal et comprenant un film conducteur (25) ou un vernis conducteur (23), dans lequel une tôle (19a) de l'élément de fermeture sert de support, ou
l'électrode de capteur (7) comprend la tôle (19a) de l'élément de fermeture (6).

2. Système de capteur selon la revendication 1, **caractérisé en ce que** l'unité d'évaluation (4) est conçue pour comparer la valeur de mesure (S_{Mess}) du capteur (1) à une valeur limite (S_{Grenz}), ou
l'unité d'évaluation (4) peut déterminer si la variation relative (ΔS_{Mess}) de la valeur de mesure est supérieure à une valeur limite prédéterminée, et
lorsque la valeur limite est dépassée, un signal de capteur (Sₛₑₙₛₒᵣ) ralentissant la vitesse de l'élément de fermeture (6) ou arrêtant son déplacement peut respectivement être émis vers une commande de moteur (5), dans lequel de manière préférée
une première valeur limite (S_{Grenz1}) est définie dans l'unité d'évaluation (4) pour une première zone (Z1), présentant une première distance (a) par rapport à l'élément formant capteur (2), de la région de détection de signal, dans lequel un signal de capteur (Sₛₑₙₛₒᵣ) ralentissant le déplacement de l'élément de fermeture (6) est émis vers la commande de moteur (5) lorsque la valeur limite (S_{Grenz1}) est dépassée, et pour une autre zone (Z2) présentant une autre distance (b), dans lequel b < a, un signal de capteur (S_{Sensor}) arrêtant le déplacement de l'élément de fermeture (6) est émis vers la commande de moteur.

3. Système de capteur selon la revendication 1 ou 2, **caractérisé en ce que** l'élément formant capteur (2) est agencé au niveau de l'élément de fermeture (6), en particulier au niveau du hayon (6), ou est intégré dans l'élément de fermeture (6), en particulier dans le hayon (6), dans lequel de manière préférée
des composants existants de l'élément de fermeture (16) sont utilisés comme partie de l'élément formant capteur (2).

4. Système de capteur selon la revendication 1, **caractérisé en ce que** la tôle (19a) de l'élément de fermeture (6) sert d'électrode de capteur (7) et une tôle (19b) distante séparée de manière galvanique fait office d'électrode de blindage (14).

5. Système de capteur selon au moins l'une quelconque des revendications 1 à 4, **caractérisé en ce que** plusieurs capteurs (1a, b, c, d) sont munis de plusieurs éléments formant capteur (2a, b, c, d) afin de localiser les obstacles.

6. Système de capteur selon au moins la revendication 1, **caractérisé en ce que** le capteur (1) mesure la variation de capacité dans une région de détection de signal (8) au niveau de l'élément formant capteur (2), dans lequel la région de détection de signal s'étend de manière préférée d'un côté de l'élément formant capteur (2) et/ou des deux côtés de l'élément formant capteur (2) et la région de détection de signal s'étend en particulier à une distance comprise entre 50 mm et 100 mm à partir de l'élément formant capteur.

7. Système de capteur selon au moins l'une quelconque des revendications 1 à 6, **caractérisé en ce qu'**un capteur de référence capacitif (9) est agencé en dehors de la région de déplacement de l'élément de fermeture, en particulier de la région de pivotement du hayon (6), afin de détecter une variation de capacité due aux conditions ambiantes, en particulier aux précipitations.

8. Procédé permettant d'empêcher que des obstacles soient coincés dans la région d'ouverture (12) lors de la fermeture d'un élément de fermeture (6) entrainé de manière motorisé et/ou soient endommagés lors de l'ouverture, en particulier avec un dispositif selon au moins l'une quelconque des revendications 1 à 7, comprenant les étapes ci-dessous consistant à :
- déplacer l'élément de fermeture (6) afin de fermer ou ouvrir la région d'ouverture (12),
- mesurer la capacité dans une région de détection de signal (8) d'un champ électrique (11) d'un élément formant capteur (2) d'un capteur capacitif (1),
- transmettre la valeur de mesure (S_{Mess}) à une unité d'évaluation (4) qui génère un signal de capteur (S_{Sensor}) en se basant sur la valeur de mesure et la transmet à une commande de moteur (5) de l'élément de fermeture (6), ce qui ralentit ou arrête le déplacement de l'élément de fermeture (6),
dans lequel le capteur capacitif (1) possède la fonction de capteur de proximité qui détecte le déplacement d'un obstacle dans sa région de détection de signal, dans lequel la variation de capacité due à l'obstacle est d'autant plus grande que l'obstacle est plus proche du capteur,
**caractérisé en ce que** l'élément formant capteur (2) comprend une électrode de capteur (7) plate permettant de former la région de détection de signal et comprenant un film conducteur (25) ou un vernis conducteur (23), dans lequel une tôle (19a) de l'élément de fermeture sert de support, ou l'électrode de capteur (7) comprend la tôle (19a) de l'élément de fermeture (6).

9. Procédé selon la revendication 8, **caractérisé en ce que** l'unité d'évaluation compare une valeur de mesure (S_{Mess}) du capteur (1) à une valeur limite (S_{Grenz}) ou détermine si la variation relative de la valeur de mesure est supérieure à une valeur limite prédéterminée et
lorsque la valeur limite est dépassée, un signal de capteur (Sₛₑₙₛₒᵣ) ralentissant la vitesse de l'élément de fermeture (6) ou arrêtant son déplacement est respectivement émis vers la commande de moteur (5) et/ou
la valeur de mesure (S_{Mess}) est comparée à plusieurs valeurs limites, dans lequel en particulier la vitesse est réduite après le dépassement d'une première valeur limite (S_{Grenz1}) et le déplacement de l'élément de fermeture est arrêté après le dépassement d'une autre valeur limite (S_{Grenz2}).

10. Procédé selon la revendication 8 ou 9, **caractérisé en ce que** l'élément formant capteur est agencé au niveau de l'élément de fermeture (6) ou est intégré dans l'élément de fermeture (6).

11. Procédé selon au moins l'une quelconque des revendications 8 à 10, **caractérisé en ce qu'**un trajet de référence est effectué avant la mise en service du système de capteur et des augmentations de capacité dues aux conditions ambiantes sont détectées par l'unité d'évaluation (4) et sont occultées pendant le fonctionnement normal de l'élément de fermeture (6).

12. Procédé selon au moins l'une quelconque des revendications 8 à 11, **caractérisé en ce qu'**une capacité est mesurée en dehors de la région de déplacement de l'élément de fermeture (6) à l'aide d'un capteur de référence capacitif (9) et il est déterminé si la valeur de mesure ou la variation relative de la valeur de mesure dépasse une valeur limite, dans lequel, lorsque la valeur limite est dépassée, il est déterminé qu'un dépassement simultané, constaté par le capteur capacitif (1), d'une valeur limite (S_{Grenz}) n'a pas été causé par un obstacle et aucun signal de capteur (Sₛₑₙₛₒᵣ) ralentissant ou arrêtant le déplacement de l'élément de fermeture (6) n'est envoyé à la commande de moteur.

13. Procédé selon au moins l'une quelconque des revendications 8 à 12, **caractérisé en ce que** des valeurs de mesure correspondant à des influences de l'environnement comme la pluie ou la neige sont enregistrées dans l'unité d'évaluation (4) et/ou des valeurs de mesure pour différents matériaux d'obstacles possibles ainsi que les valeurs de mesure réelles sont comparées aux valeurs de mesure enregistrées.

14. Système de capteur selon au moins l'une quelconque des revendications 1 à 7, **caractérisé en ce que** des capteurs de référence externes, en particulier un capteur de pluie ou une caméra de recul, sont reliés à l'unité d'évaluation (4).
